# EUROPEAN PATENT SPECIFICATION

(11) **EP 1 302 773 B1**
(45) Date of publication and mention of the grant of the patent: **25.04.2007**
(21) Application number: 02102423.7
(22) Date of filing: 08.10.2002
(51) Int. Cl.: G01R 15/18

(54) **Screening device for Rogowski current measuring apparatus**
Abschirmvorrichtung für Rogowski-Strommessanordnung
Dispositif de blindage pour appareil de mesure de courants du type Rogowski

(30) Priority: 10.10.2001 FI 20011974
(43) Date of publication of application: 16.04.2003
(73) Proprietor: ABB Technology AG, 8050 Zürich (CH)
(72) Inventor: Mähönen, Pentti, 65320, Vaasa (FI); Peltonen, Hanna, 33210, Tampere (FI)
(74) Representative: Peltonen, Antti Sakari

(56) References cited:
- EP-A- 0 933 639
- DE-A- 4 435 864

## Description

### BACKGROUND OF THE INVENTION

The present invention relates to an object which is made of an insulating material and comprises a frame made of an insulating material, a place for a primary current conductor which passes through the frame, a current measuring element which is arranged around the place where the primary current conductor passes through the frame and formed by a Rogowski sensor, a casing which supports the coil or coils of the Rogowski sensor, and a screen structure for the Rogowski sensor.

In connection with this invention, an object made of an insulating material and comprising a frame made of an insulating material and a place for a primary current conductor which passes through the frame refers to components with such a structure, serving particularly as parts of electric equipment and being used as lead-in insulators, post insulators, combined sensors, switch parts and the like. For the sake of clarity, in the following the invention is described mainly in connection with its perhaps most common application, i.e. a lead-in insulator.

A problem with lead-in insulator solutions, where also current that passes through the insulator is measured, is that a current measuring sensor must be arranged accurately close to a primary current conductor. The accuracy and reliability of measurement results depend on the location and position of the current measuring sensor in respect of the primary current conductor, and therefore the sensors must be mounted carefully. The measuring sensor is fixed inside the insulator, which means that if the position of the measuring sensor is twisted during casting, it cannot be corrected afterwards. If one and the same insulator is provided with a current measuring sensor and one or more other sensors for voltage measurement and detection, for instance, it is very difficult to position these sensors in respect of each other and to maintain this positioning during the casting of the insulator frame.

Insulating objects of the type disclosed in the invention are typically used in surroundings which cause interference to sensitive current measuring elements. Measurement interferences are particularly caused by transformers and apparatuses generally used for transmission of electricity and for electric drives in industrial environments. Possible interferences to measuring sensors, particularly electromagnetic radiation, must be prevented so that the measurement results obtained from the sensors represent the variable being measured.

Such objects which are in accordance with the introduction and made of an insulating material and which solve the above-mentioned problems concerning how the measuring sensors and the structure for protecting them against the electric field are supported during casting are disclosed in published EP application 0933639 and German Offenlegungsschrift 4435864, for example. For supporting the Rogowski sensor, they use a casing or a shield made of an insulating material. The screening of the Rogowski sensor, for its part, is implemented by providing the structure or casing supporting the coil or coils of the sensor with a conductive or at least a semi-conductive surface layer, which, being earthed, protects the coil or coils from interference caused by the electric field. In published EP application 0933639, the surface layer is most preferably implemented as a metal coating on the outer surface of the casing made of an insulating material. In German Offenlegungsschrift 4435864, the shield of the sensor is a sleeve made of silicone rubber, which is provided with a highly conductive or semi-conductive surface layer forming the actual screen electrode.

In both of these cases, the screening of the Rogowski sensor requires that a specific layer be provided on the surface of the casing or shield supporting the coil or coils of the sensor. In order to provide such a layer it is necessary to have a specific manufacturing stage, which complicates the manufacture of the shield or casing and increases costs.

### SUMMARY OF THE INVENTION

It is an object of the present invention to provide an object which is made of an insulating material and in which the supporting and screening of a current measuring sensor is implemented by means of a structure simpler than before. This is achieved by an object made of an insulating material, which is characterized by what is disclosed in the independent claim. The preferred embodiments of the invention are disclosed in the dependent claims.

The invention is based on manufacturing a casing supporting the current measuring sensor from a semi-conductive material which itself forms a screen structure for the current measuring sensor. In accordance with the invention, the casing or parts thereof are manufactured in one casting stage and the casing need not be separately provided with a screen electrode.

The protective casing of the current measuring sensor preferably comprises plastic, with which filling agents are blended to make the plastic semi-conductive. Preferably the filling agent comprises fibres, such as carbon fibres and/or metal fibres, particularly stainless steel fibres, to the extent that the resistivity of the semi-conductive casing is within the range of 1 to 40 Ωcm.

The screening implemented according to the invention is simple and inexpensive, yet secure and reliable.

### LIST OF FIGURES

In the following the invention will be described in greater detail in association with preferred embodiments and with reference to the attached drawings, in which:
Figure 1 is a profile of a lead-in insulator constituting an exemplary embodiment of the invention;
Figure 2 is a cross section of the lead-in insulator of Figure 1 taken along the line A - A of Figure 1;
Figures 3 and 4 show parts of the casing of a current measuring sensor forming part of the lead-in insulator of Figures 1 and 2; and
Figure 5 is a perspective view of the casing implemented by connecting the parts of Figures 3 and 4.

### DETAILED DESCRIPTION OF THE INVENTION

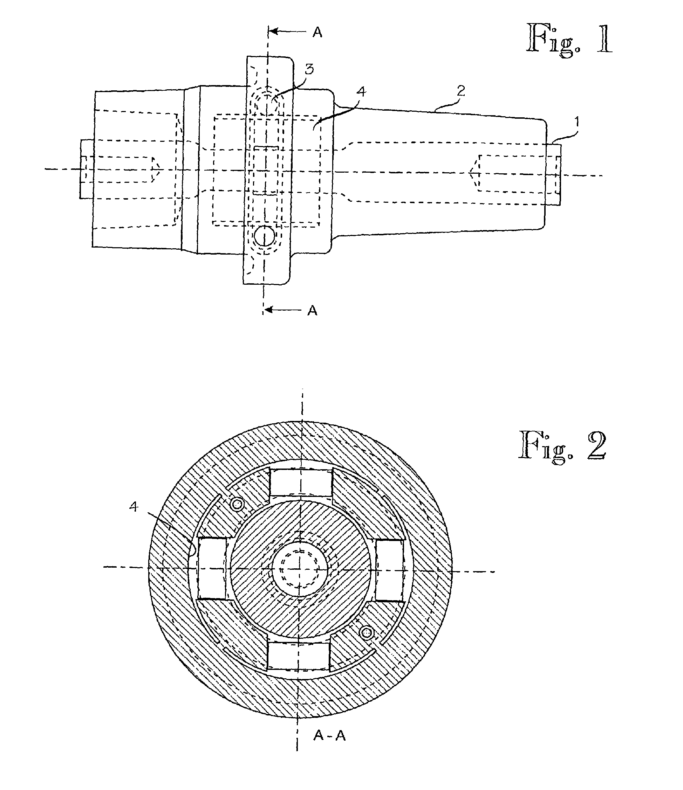

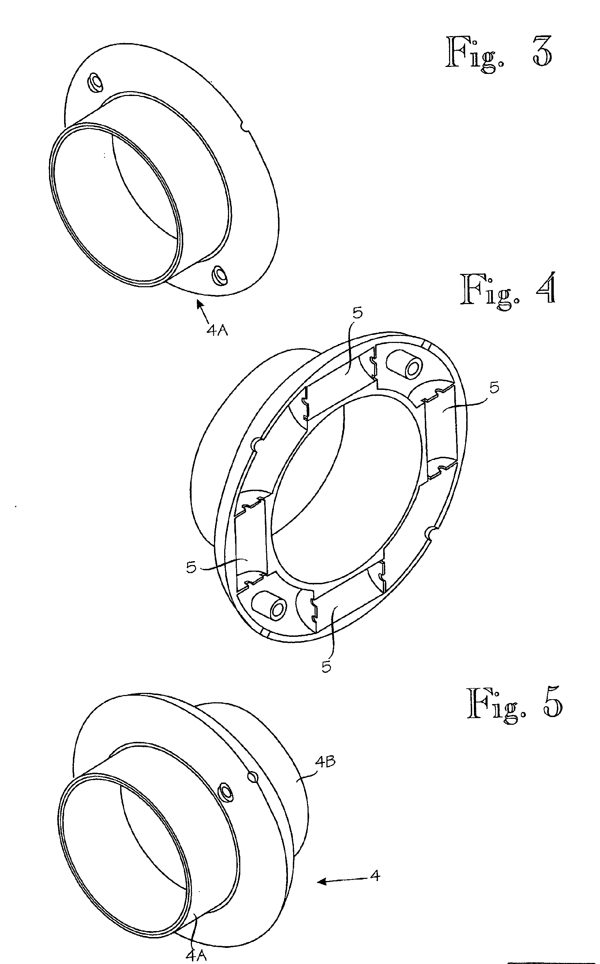

The lead-in insulator according to Figure 1 comprises an insulator frame 2, through which a primary current conductor 1 is led. The lead-in insulator of the embodiment also comprises a casing 4, inside of which a current measuring element or elements 3 are supported. The casing 4 consists of two parts 4A, 4B, which, joined together, form a tight bedding for measuring sensors to be placed in the casing. The casing includes accurately shaped locations 5 for partial coils forming the Rogowski sensor, the coils, according to Figures 2 and 4, being straight coils. In the embodiment shown in the figures, the Rogowski sensor thus comprises a plurality of series connected coils wound on bobbins arranged in the shape of a polygon around the primary current conductor of the insulator and perpendicularly to its axial direction. The Rogowski sensor could also consist of only one toroidal coil. In any case, when the casing 4 of the invention is used, it is simple to place the coil or coils in their exact places. The casing 4 can also be provided with specific routes for connecting conductors, preferably plastic-insulated conductors, between different partial coils and any separate return conductor. Exact placement of connecting conductors inside the casing allows the coils to be always mounted exactly in the same position, which improves the measuring accuracy.

Unlike in the exemplary embodiment of Figure 1, the insulating object of the invention can also be a post insulator, for instance, which is intended to be used with a conductor rail, such as a round and hollow conductor rail, led through the insulator. In this case, the insulating object of the invention does not comprise a primary current conductor, but only an opening or a place through which the primary current conductor or the conductor rail can be led.

To ensure a reliable current measurement by using a Rogowski sensor, the sensor should be protected against external interference. The screening is implemented according to the invention so that the casing 4 is made of a semi-conductive material. If the resistivity of the material is within the range of 1 to 40 Ωcm, the casing itself provides a sufficient screening for the Rogowski sensor against low-frequency, such as mains-frequency, interference in particular.

At its simplest, the casing 4 is manufactured by injection moulding from plastic, with which filling agents are blended in order to make the plastic semi-conductive in a desired manner. In practice, most preferably the filling agent comprises fibres, such as carbon fibres and/or metal fibres, particularly stainless steel fibres. Suitable commercial products, the conductivity of which is at the desired level in the application according to the invention, include trade names Lexan SP7750, the manufacturer of which is General Electric Company and which comprises polycarbonate as a matrix material and includes ca. 35 percent by volume of carbon fibres, and Faradex XC612, the manufacturer of which is LNP Engineering Plastics, Inc. and which includes ca. 9.4 percent by volume of stainless steel fibres. These materials provide for the coil or coils of the Rogowski sensor a screening effect corresponding to a screening provided by a metal casing. It is to be stated that common conductive polymers presently in use are not conductive enough to be used as such for the purpose of the invention.

As the entire casing 4 is made of a semi-conductive material, it has to be attended to that the measuring coil or coils are not in conductive contact with the casing. This can be achieved by many alternative ways, especially as the voltage level of the sensor is relatively low, in practice only about one volt. The coils or windings can be insulated by a suitable adhesive tape, for instance, or an insulating film can be used between the casing and the coil. Also, the conductors combining the coils are plastic-insulated conductors and the connection pads of the bobbins are placed so as to provide a sufficiently large clearance. The casting method of the casing also gives an alternative, since depending on the rate of casting, for instance, the casing surface will be provided with a surface layer which insulates more efficiently than the rest of the material and comprises less fibres than the rest of the material.

According to the preferred embodiment of the invention, the casing 4 is made of two halves, which are shown in Figures 3 and 4. When parts 4A and 4B of the casing according to Figures 3 and 4 are joined together, the casing 4 of Figure 5 is formed. The halves can be joined together by e.g. a screw joint, as shown in connection with the embodiment of the figures, by gluing, or the casing parts can be arranged to be engaged by e.g. a tongue locking the halves together, when they are pressed against each other. Fastening can also be accomplished at separate fastening points arranged on the surface of the casing. The inner surface of the casing may also comprise guides with which the casing halves are accurately aligned during mounting. The edge of the casing halves may also each comprise a semi-circular recess, forming a full circle after the halves are joined. The opening thus formed allows conductors connected to the measuring sensors to be brought out from the inside of the casing for utilization of the measurement results.

Since, according to the invention, the electrical conductivity of the manufacturing material of the casing is poorer than that of metal, a current with a low frequency, e.g. 50 Hz, does not induce eddy currents in the casing to the extent that the signal being measured would attenuate disadvantageously. Consequently, when the halves of the casing 4 are joined together, it is not necessary to prevent the screen structure from forming a closed loop, which is the case when the shield is made of an electrically highly conductive material, such as metal. If it is necessary to reliably avoid the formation of a closed loop, the edges of the casing halves can be arranged so as to overlap on the outer circumference and a gap can be provided on the inner circumference. Another alternative is to use the above-mentioned casting method which reduces the surface conductivity of the casing and thus to avoid the forming of a closed loop.

To have the desired screening effect, the casing 4 should be earthed. Depending on the resistivity of the manufacturing material of the casing and the manner of joining the halves 4A and 4B together, i.e. whether they are arranged in good electrical contact with each other or whether a breaking of the current circuit is carried out between them, it may be necessary that both casing halves 4A and 4B are earthed separately to achieve the desired screening effect.

After the casing halves 4A and 4B are joined, the casing 4 is cast in resin, whereupon the actual insulator structure is formed. For the casting the casing 4 is supported in its place in the mould. The casing can be supported in the mould e.g. by the use of supports fastened under the fastening screws of the casing halves or by other similar means to make the casing remain reliably in place during casting. Casting in resin is carried out by vacuum moulding, for instance, whereby the resin penetrates the casing through holes in the casing, filling all empty cavities. Consequently, both the casing and the components inside the casing remain firmly in their places in the insulator.

If the insulating object of the invention, such as a lead-in insulator, is also to be provided with a voltage measuring sensor, either for voltage detection of the primary current conductor 1 or for the actual voltage measurement, the casing 4 of the invention can, if required, also be used for this purpose. The casing 4 can be arranged to be a part of a voltage measuring sensor based on capacitive voltage division by connecting the casing to the ground with a capacitance, which forms a lower capacitance of the voltage divider, and an upper capacitance forms between the primary conductor and the casing. The lower capacitance can also be integrated into the casing by using a multi-layer injection moulding method to press an insulating layer onto the semi-conductive casing, on its inner circumference, and a new semi-conductive or conductive layer on top of it. This conductive layer can also be a metal coating. Since the semi-conductive casing is earthed, said insulating layer can function as the lower capacitance, and the upper capacitance is formed between the semi-conductive/conductive layer and the primary current conductor. If the lower capacitance thus formed is not sufficient, a capacitor can be connected parallel to it.

The casing 4 can naturally also support various measuring sensors for voltage measurement, for instance, but then they have to be insulated from the semi-conductive material of the casing 4.

The shape of the casing 4 is optimised for the space to be used. The coils have specific placement points in the casing, but the rest of the casing may have any shape.

It is obvious to a person skilled in the art that the basic idea of the invention can be implemented in various ways. Thus the invention and the embodiments thereof are not restricted to the above examples but may vary within the scope of the claims.

## Claims

1. An object which is made of an insulating material and comprises a frame (2) made of an insulating material, a place for a primary current conductor (1) which passes through the frame (2), a current measuring element (3) which is arranged around the place where the primary current conductor passes through the frame and formed by a Rogowski sensor, a casing (4, 4A, 4B) which supports the coil or coils of the Rogowski sensor, and a screen structure for the Rogowski sensor, **characterized in that**, to achieve the screen structure, the casing (4, 4A, 4B) is made of a semi-conductive material.

2. An object as claimed in claim 1, **characterized in that** the casing (4, 4A, 4B) comprises plastic, with which filling agents are blended to make the plastic semi-conductive.

3. An object as claimed in claim 2, **characterized in that** the filling agent comprises fibres, such as carbon fibres and/or metal fibres, particularly stainless steel fibres.

4. An object as claimed in any one of claims 1 to 3, **characterized in that** the resistivity of the semi-conductive casing (4, 4A, 4B) is within the range of 1 to 40 Ωcm.

5. An object as claimed in any one of claims 1 to 4, **characterized in that** the casing (4) comprises two halves (4A, 4B) which are earthed in order to provide a screening effect.

6. An object as claimed in any one of claims 1 to 5, **characterized in that** the casing (4, 4A, 4B) is arranged to be a part of a voltage measuring sensor based on capacitive voltage division so that the casing is connected to the ground with a capacitance, which forms a lower capacitance of the voltage divider, and an upper capacitance forms between the primary conductor (1) and the casing.

7. An object as claimed in any one of claims 1 to 6, **characterized in that** the Rogowski sensor comprises a plurality of series connected coils wound on bobbins arranged in the shape of a polygon around the place where the primary current conductor (1) passes through the frame, perpendicularly to the axial direction of the primary current conductor.

## Patentansprüche

1. Gegenstand, der aus einem Isoliermaterial hergestellt ist und einen aus einem Isoliermaterial hergestellten Rahmen (2), einen Ort für einen durch den Rahmen (2) verlaufenden Primärstromleiter (1), ein Strommesselement (3), das um den Ort angeordnet ist, an dem der Primärstromleiter durch den Rahmen verläuft, und das durch einen Rogowski-Sensor gebildet ist, ein Gehäuse (4, 4A, 4B), das die Wicklung oder die Wicklungen des Rogowski-Sensors trägt, und einen Abschirmaufbau für den Rogowski-Sensor aufweist, **dadurch gekennzeichnet, dass** das Gehäuse (4, 4A, 4B) zum Erhalt des Abschirmaufbaus aus einem Halbleitermaterial hergestellt ist.

2. Gegenstand nach Anspruch 1, **dadurch gekennzeichnet, dass** das Gehäuse (4, 4A, 4B) einen Kunststoff aufweist, dem Füllmittel beigefügt sind, wodurch der Kunststoff halbleitend wird.

3. Gegenstand nach Anspruch 2, **dadurch gekennzeichnet, dass** das Füllmittel Fasern aufweist, beispielsweise Kohlenstofffasern und/oder Metallfasern, insbesondere Fasern aus rostfreiem Stahl.

4. Gegenstand nach einem der Ansprüche 1 bis 3, **dadurch gekennzeichnet, dass** der spezifische Widerstand des halbleitenden Gehäuses (4, 4A, 4B) innerhalb eines Bereichs von 1 bis 40 Ωcm liegt.

5. Gegenstand nach einem der Ansprüche 1 bis 4, **dadurch gekennzeichnet, dass** das Gehäuse (4) zwei geerdete Hälften (4A, 4B) aufweist, um so einen Abschirmeffekt vorzusehen.

6. Gegenstand nach einem der Ansprüche 1 bis 5, **dadurch gekennzeichnet, dass** das Gehäuse (4, 4A, 4B) als ein Teil eines Spannungsmesssensors angeordnet ist, der auf einer kapazitiven Spannungsteilung beruht, so dass das Gehäuse mit der Erde über eine Kapazität verbunden ist, die eine untere Kapazität des Spannungsteilers bildet, und dass eine obere Kapazität zwischen dem Primärleiter (1) und dem Gehäuse gebildet ist.

7. Gegenstand nach einem der Ansprüche 1 bis 6, **dadurch gekennzeichnet, dass** der Rogowski-Sensor eine Vielzahl von in Reihe verbundener Wicklungen aufweist, die auf Spulenkörper gewickelt sind, welche polygonal um den Ort, an dem der Primärstromleiter durch den Rahmen verläuft, und senkrecht zu der Axialrichtung des Primärstromleiters angeordnet sind.

## Revendications

1. Objet qui est constitué d'un matériau isolant et qui comprend un cadre (2) constitué d'un matériau isolant, un emplacement pour un conducteur de courant principal (1) qui passe à travers le cadre (2), un élément de mesure du courant (3) qui est agencé autour de l'emplacement où le conducteur de courant principal passe à travers le cadre et formé par un capteur de Rogowski, un boîtier (4, 4A, 4B) qui supporte la bobine ou les bobines du capteur de Rogowski, et une structure d'écran pour le capteur de Rogowski, **caractérisé en ce que**, pour obtenir la structure d'écran, le boîtier (4, 4A, 4B) est constitué d'un matériau semi-conducteur.

2. Objet selon la revendication 1, **caractérisé en ce que** le boîtier (4, 4A, 4B) comprend une matière plastique, à laquelle sont mélangés des agents de remplissage pour rendre la matière plastique semi-conductrice.

3. Objet selon la revendication 2, **caractérisé en ce que** l'agent de remplissage comprend des fibres, telles que des fibres de carbone et/ou des fibres métalliques, en particulier des fibres d'acier inoxydable.

4. Objet selon l'une quelconque des revendications 1 à 3, **caractérisé en ce que** la résistivité du boîtier semi-conducteur (4, 4A, 4B) se situe dans la gamme de 1 à 40 Ωm.

5. Objet selon l'une quelconque des revendications 1 à 4, **caractérisé en ce que** le boîtier (4) comprend deux moitiés (4A, 4B) qui sont mises à la terre afin de donner un effet d'écran.

6. Objet selon l'une quelconque des revendications 1 à 5, **caractérisé en ce que** le boîtier (4, 4A, 4B) est agencé pour faire partie d'un capteur de mesure de la tension sur la base de la réduction de tension de capacité de sorte que le boîtier est relié à la terre avec une capacité, qui forme une capacité inférieure du réducteur de tension, et une capacité supérieure se forme entre le conducteur principal (1) et le boîtier.

7. Objet selon l'une quelconque des revendications 1 à 6, **caractérisé en ce que** le capteur de Rogowski comprend une pluralité de bobines connectées en série enroulées sur des bobines agencées sous la forme d'un polygone autour de l'emplacement où le conducteur de courant principal (1) passe à travers le cadre, perpendiculairement à la direction axiale du conducteur de courant principal.
